# EUROPEAN PATENT SPECIFICATION

(11) **EP 1 764 843 B1**
(45) Date of publication and mention of the grant of the patent: **20.02.2008**
(21) Application number: 05020017.9
(22) Date of filing: 14.09.2005
(51) Int. Cl.: H01L 41/083, H01L 41/09, H01L 41/047, H04R 17/00, G10K 9/122

(54) **Piezoelectric ceramic element and piezoelectric components using the same**
Piezoelektrisches Keramikelement and Bauteile daraus
Elément piézo-électrique et dispositifs utilisant celui-ci

(43) Date of publication of application: 21.03.2007
(73) Proprietor: Ariose Electronics Co., Ltd., Taoyuan, (TW)
(72) Inventor: Lu, Yao Tsun, Taoyuan (TW)
(74) Representative: Zeitler, Giselher

(56) References cited:
- EP-A- 1 501 074
- WO-A-03/094252
- WO-A-20/05069393
- US-A1- 2004 251 784
- PATENT ABSTRACTS OF JAPAN vol. 015, no. 359 (E-1110), 11 September 1991 (1991-09-11) -& JP 03 141677 A (NEC CORP), 17 June 1991 (1991-06-17)
- PATENT ABSTRACTS OF JAPAN vol. 1995, no. 07, 31 August 1995 (1995-08-31) & JP 07 094796 A (FUJI ELELCTROCHEM CO LTD), 7 April 1995 (1995-04-07)

## Description

### BACKGROUND OF THE INVENTION

### Field of Invention

The present invention relates to a piezoelectric actuator including piezoelectric elements composed of plural ceramic layers to form positive and negative electrode conductive circuits.

### Related Art

The piezoelectric actuator typically uses a piezoelectric element to be stimulated by driving signals received from positive and negative electrodes to produce sound.

The conventional piezoelectric element includes a ceramic sheet of single layer attached on one surface of a metal plate. Each ceramic sheet has an exposed surface coated with a conductive material as an electrode layer for a conducting line from a positive electrode of a signal provider to be soldered thereon. A negative electrode of the signal provider is soldered on the metal board. As such, the driving signals can be transmitted from outside to stimulate the piezoelectric element to resonate and the piezoelectric element can be used for the piezoelectric actuator to produce sound.

However, a single layer of ceramic sheet is attached on the metal plate. Therefore, higher driving voltage is required to obtain better output sound. If the signal provider inputs lower voltage signal, it is hard to obtain good resonant sound between the single ceramic sheet and the metal plate. This is an issue needed to be overcome.

WO 03/094252 discloses a piezoactuator having a base body that contains a stack of superimposed piezoelectric layers and electrode layers disposed between them, in which the piezoelectric layers contain ceramic material and are sintered together, in which, perpendicular to the electrode layers, a hole passes through the base body, into which a pin is inserted.

EP 1 501 074 A2 discloses a piezoelectric vibrator having first and second piezoelectric vibrating plates supported by pillars on an enclosure. Spacers are mounted on both end sides of the second piezoelectric vibrating plate to prevent contact between the vibrating plates, thus preventing damage. Other spacers are mounted on the main surface of the enclosure in positions corresponding to the first mentioned spacers to prevent contact with the main surface of the enclosure, thus preventing damage to the second piezoelectric vibrating plate. However, none of them includes a driving circuit die as in the piezoelectric actuator of the present invention.

### SUMMARY OF THE INVENTION

In the first aspect, the present invention is to provide a piezoelectric actuator with lower driving voltage.
Accordingly, the piezoelectric actuator comprising at least one piezoelectric element mounted to an insulating bracket, the piezoelectric element comprising at least one piezoelectric ceramic unit attached to a metal plate, the piezoelectric ceramic unit comprising: a top-layer, a bottom-layer and an intermediate-layer ceramic sheet stacked to each other; a first alloy layer of silver and palladium interposed between the top-layer and the intermediate-layer ceramic sheets; a second alloy layer of silver and palladium interposed between the intermediate-layer and the bottom-layer and ceramic sheets; wherein a first insulating aperture is formed on the first alloy layer, and a second insulating aperture is formed on the second alloy layer, wherein a positive electrode via hole is formed to pass through all ceramic sheets and the second alloy layer but pass within the first insulating aperture, and a negative electrode via hole is formed to pass through all ceramic sheets and the first alloy layer but pass within the second insulating aperture, a top silver layer coated on an exposed surface of the top-layer ceramic sheet and filled in the positive electrode via hole; a bottom silver layer coated on an exposed surface of the bottom-layer ceramic sheet and filled in the negative electrode via hole, wherein a top insulating aperture is formed on the top silver layer to insulate the top silver layer from the silver filled in the negative electrode via hole, wherein a bottom insulating aperture is formed on the bottom silver layer to insulate the bottom silver layer from the silver filled in the positive electrode via hole, thereby, the top silver layer and the second alloy layer are connected by the silver filled in the positive electrode via hole to form a positive electrode circuit, and the bottom silver layer and the first alloy layer are connected by the silver filled in the negative electrode via hole to form a negative electrode circuit, the metal plate with the bottom-layer ceramic sheet is attached on one surface to connect the negative electrode circuit so that an exposed end can be used as a negative electrode terminal, and the top silver layer can be used as a positive electrode terminal; the insulating bracket comprising a positive electrode conductive part contacted with the metal plate, a negative electrode conductive part contacted with the top silver layer and at least one connecting pin extending from each of the positive and the negative electrode conductive part to receive voltage signals; and a driving circuit die having an output port connected to the connecting pins to be integratedly form with the insulating bracket, and an input port with a sound positive electrode, a sound negative electrode, a signal input and a standby mode so that voltage signals can be transmitted to the piezoelectric element.

An alloy layer of silver (Ag) and palladium (Pd) is interposed between every two ceramic sheets to form a positive or a negative conductive electrode. The alloy layer includes a predetermined proportion of silver. Silver has excellent conductivity but has a melting point only of 961 °C; however, Pd has both good conductivity and higher melting point of 1.554°C. Therefore, the alloy layer of Ag and Pd can endure the high-temperature sintering at 1.150°C to complete the piezoelectric ceramic unit.

A positive and a negative electrode via holes are formed through the ceramic layers and the alloy layers, respectively. A silver layer is then coated on the exposed surface of each top-layer and bottom-layer ceramic sheet to fill in the corresponding positive or negative electrode via hole. Moreover, each alloy layer and silver layer is formed with an insulating aperture surrounding corresponding positive or negative electrode via hole so as to construct a positive and a negative electrode circuit in the piezoelectric ceramic unit to connect a voltage signal. The driving voltage is reduced because of plural insulating ceramic sheets cooperated with plural conducting alloy layers and silver layers to form the conductive circuit.

The piezoelectric actuator is easy for mass productions, which can be driven to produce sound at lower voltage without messy extending conductive lines. At least one piezoelectric ceramic unit with a bottom silver layer attached to a metal plate makes a piezoelectric element. The piezoelectric element combines an insulating bracket including a positive and a negative electrode conductive part to form the piezoelectric actuator.

In a preferred embodiment a damping pad is provided to adhere the piezoelectric element on an insulating base with a driving circuit die mounted inside.

In a further preferred embodiment the piezoelectric element is mounted on an annular support formed in a housing by silicon glue.

The present invention will become more fully understood from the following detailed description of a preferred embodiment.

### BRIEF DESCRIPTION OF THE DRAWINGS

- FIG. 1: is an exploded perspective view of a piezoelectric actuator according to the present invention;
- FIG. 2: is a cross section view of a semi-manufacture of a piezoelectric ceramic unit;
- FIG. 3: is a cross section view of the piezoelectric ceramic unit;
- FIG. 4: is a cross section view of the piezoelectric actuator;
- FIG. 5: is a perspective view of a piezoelectric actuator used for a socket;
- FIG. 6: is a cross section view of the piezoelectric actuator showing a positive electrode conductive part;
- FIG. 7: is a cross section view of the piezoelectric actuator showing a negative electrode conductive part;
- FIG. 8: is a cross section view of the piezoelectric actuator surface-mounted on a substrate;
- FIGS. 9a and 9b: show a driving circuit die and a cross section view of the driving circuit die integrated with the piezoelectric actuator;
- FIG. 10: is a perspective view of a piezoelectric loudspeaker according to one preferred embodiment;
- FIG. 11: is a perspective view of a piezoelectric loudspeaker according to another preferred embodiment;
- FIG. 12: is a perspective view of a piezoelectric loudspeaker according to still another preferred embodiment;
- FIG. 13: is a cross section view of FIG. 12;
- FIG. 14: is a cross section view of a piezoelectric buzzer according to one preferred embodiment; and
- FIG. 15: is a cross section view of a piezoelectric buzzer according to one preferred embodiment.

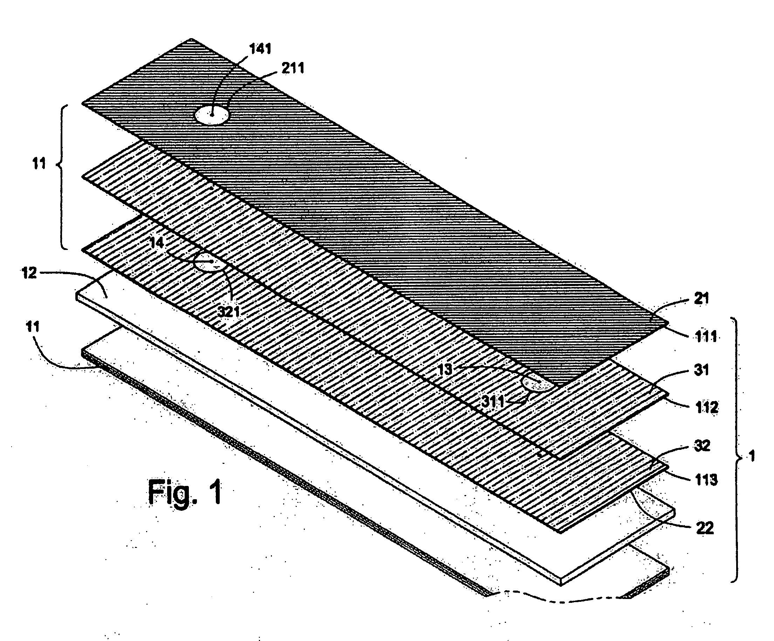

Referring to Figure 1, a piezoelectric ceramic unit 11 and a piezoelectric element 1 are illustrated. The piezoelectric ceramic unit 11 includes a top-layer ceramic sheet 111, a bottom-layer ceramic sheet 113 and at least one intermediate-layer ceramic sheet 112. These rectangular ceramic sheets 111, 112 and 113 are stacked to each other and will be processed in an equalized pressure by hot water for sintering at high temperature thereafter.

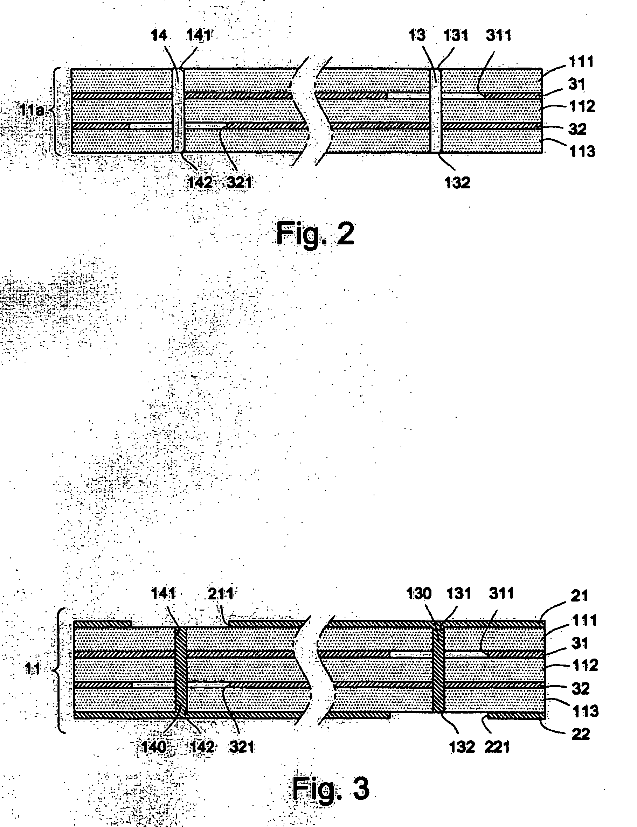

A first alloy layer 31 is interposed between the top-layer and the intermediate-layer ceramic sheets 111 and 112, and a second alloy layer 32 is interposed between the intermediate-layer and the bottom-layer and ceramic sheets 112 and 113. The first and the second alloy layers 31 and 32 are composed of silver (Ag) and palladium (Pd) to tightly combine all the ceramic sheets to form the piezoelectric ceramic unit 11 after sintering, as shown in Figure 2. Therefore, the first and the second alloy layers 31 and 32 are insulated by the intermediate-layer ceramic sheet 112.

At least one insulating aperture is formed on each alloy layer. In the preferred embodiment, a first insulating aperture 311 is formed on the first alloy layer 31, and a second insulating aperture 321 is formed on the second alloy layer 32. Moreover, a positive electrode via hole 13 and a negative electrode via hole 14 are formed to pass through all the ceramic sheets and a corresponding alloy layer.

The positive electrode via hole 13 includes a positive electrode top hole 131 formed on the top-layer ceramic sheet 111, which sequentially connects the top-layer ceramic sheet 111, the intermediate-layer sheet 112, the second alloy layer 32 and the bottom-layer ceramic sheet 113 but passes within the first insulating aperture 311 of the first alloy layer 31. Similarly, the negative electrode via hole 14 includes a negative electrode top hole 141 formed on the top-layer ceramic sheet 111, which sequentially connects the top-layer ceramic sheet 111, the intermediate-layer sheet 112, the first alloy layer 31 and the bottom-layer ceramic sheet 113 but passes within the second insulating aperture 321 of the second alloy layer 32.

Referring to Figure 3, after a semi manufacture 11 a of the piezoelectric ceramic unit 11 is completed, a top silver layer 21 and a bottom silver layer 22 are coated on the surfaces of the top-layer and the bottom-layer ceramic sheets 111 and 113 and filled in the positive and the negative electrode via holes 13 and 14, respectively. Moreover, a top insulating aperture 211 is formed on the top silver layer 21 enclosing the negative electrode top hole 141 to insulate the top silver layer 21 from the silver filled in the negative electrode via hole 14. Similarly, a bottom insulating aperture 221 is formed on the bottom silver layer 22 enclosing the positive electrode top hole 131 to insulate the bottom silver layer 22 from the silver filled in the positive electrode via hole 13. Therefore, the top silver layer 21 and the second alloy layer 32 are connected by the silver filled in the positive electrode via hole 13 to form a positive electrode circuit 130, and the bottom silver layer 22 and the first alloy layer 31 are connected by the silver filled in the negative electrode via hole 14 to form a negative electrode circuit 140. In that, the piezoelectric ceramic unit 11 is completed to have the top silver layer 21 as the contact terminal of the positive electrode circuit 130 and the bottom silver layer 22 as the contact terminal of the negative electrode circuit 140.

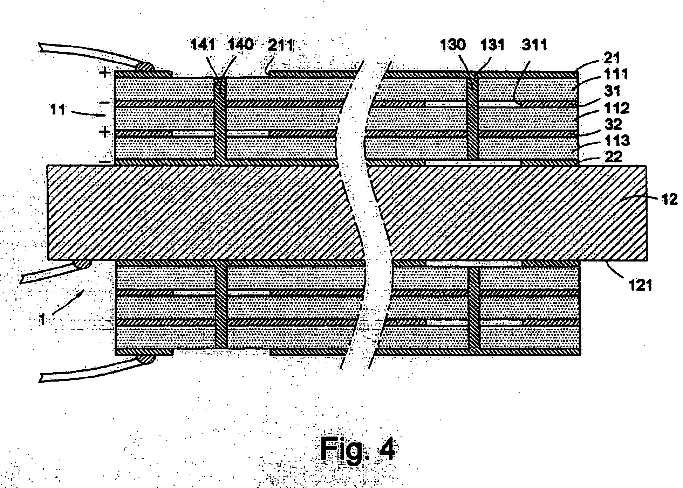

Referring to Figures 1 and 4, two piezoelectric ceramic units 11 are used to attach on two opposite surfaces of a rectangular metal plate 12, respectively. In the preferred embodiment, the bottom silver layer 22 is contacted with the metal plate 12 to have an exposed end 121 of the metal plate 12 without piezoelectric ceramic unit 11 formed as a negative electrode terminal, and each top silver layer 21 of two piezoelectric units 11 as a positive electrode terminal. In that, the piezoelectric element 1 with the piezoelectric ceramic unit 11 mounted on at least one side is completed.

In using the piezoelectric element 1, a positive electrode signal source is soldered on each top silver layer 21 and a negative electrode signal source is soldered on the exposed end 121. As such, the positive electrode voltage signal is conducted by the top silver layer 21 as well as the second alloy layer 32 via the positive electrode circuit 130, and the negative electrode voltage signal is conducted by the bottom silver layer 22 as well as the first alloy layer 31 via the negative electrode circuit 140. That is, a conductive circuit with alternative positive or negative voltage signal between two adjacent ceramic sheets or between adjacent ceramic sheet and metal plate is formed in the piezoelectric element 1. Therefore a driving voltage is reduced to obtain better sound output for the applications.

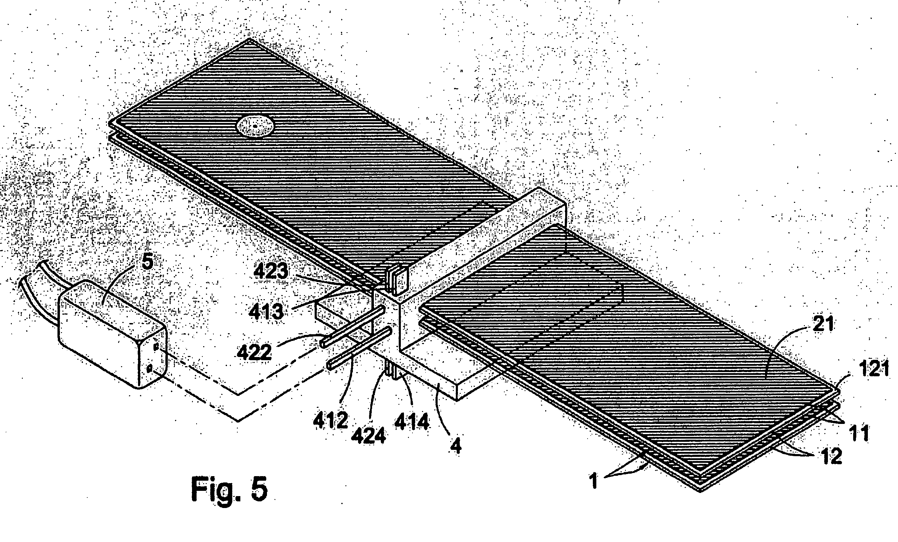

Referring to Figure 5, at least one piezoelectric element 1 is used to make a piezoelectric actuator. In the preferred embodiment, two piezoelectric elements 1 are mounted to an insulating bracket 4 which includes a positive and a negative electrode conductive parts 41 and 42 packaged therein

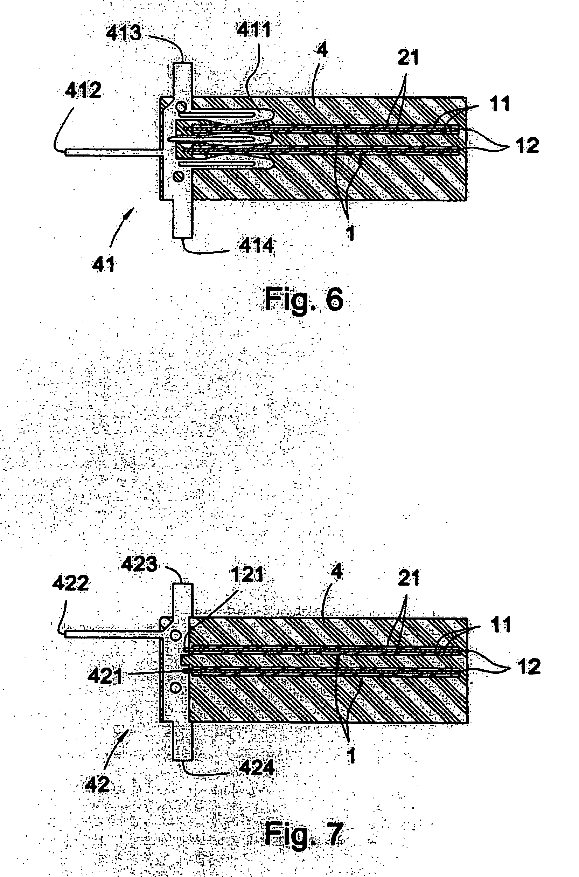

As shown in Figure 6, the positive electrode conductive part 41 includes three contact terminals 411 to clamp two piezoelectric elements 1 there between from one end and contact with the top silver layer 21, respectively. The positive electrode conductive part 41 further includes three connecting pins 412, 413 and 414 extending outwardly from the front, the top and the bottom thereof.

As shown in Figure 7, the negative electrode conductive part 42 includes two clamp openings 421 each to receive the exposed end 121 of the metal plate 12 of the piezoelectric element 1. The negative electrode conductive part 42 also includes three connecting pins 422, 423 and 424 extending outwardly from the front, the top and the bottom thereof.

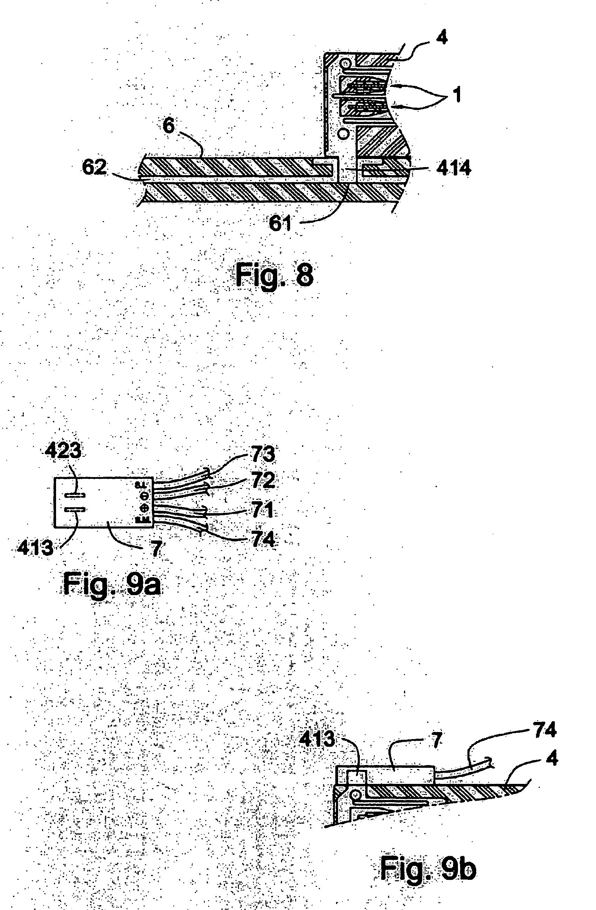

Accordingly, a connector 5 can be used to connect with the piezoelectric actuator by the connecting pins 412 and 422, as shown in Figure 5, to receive the voltage signals therefrom. Or, the connecting pins 414 and 424 are directly used to insert in corresponding slots 61 provided in a substrate 6, as shown in Figure 8, to receive the voltage signals from a circuit 62 of the substrate 6. The input voltage signals will drive the piezoelectric actuator under resonance to produce sound.

Furthermore, the driving circuit can be made as a die 7, as shown in Figure 9a, to be integratedly formed with the piezoelectric actuator, as shown in Figure 9b.

The driving circuit is an integrated circuit and includes a DC converter and an amplifier (AMP). An input port of the die 7 includes a sound positive electrode (V+) 71, a sound negative electrode (V-) 72, a signal input (SI) 73 and a standby mode (SM) 74. An output port 75 of the die 7 can be directly mounted to the connecting pins 413 and 423 of the piezoelectric actuator, so as to transmit voltage signals. Moreover, the die 7 can include a bluetooth module for wireless transmitting sound signals generated by the piezoelectric actuator.

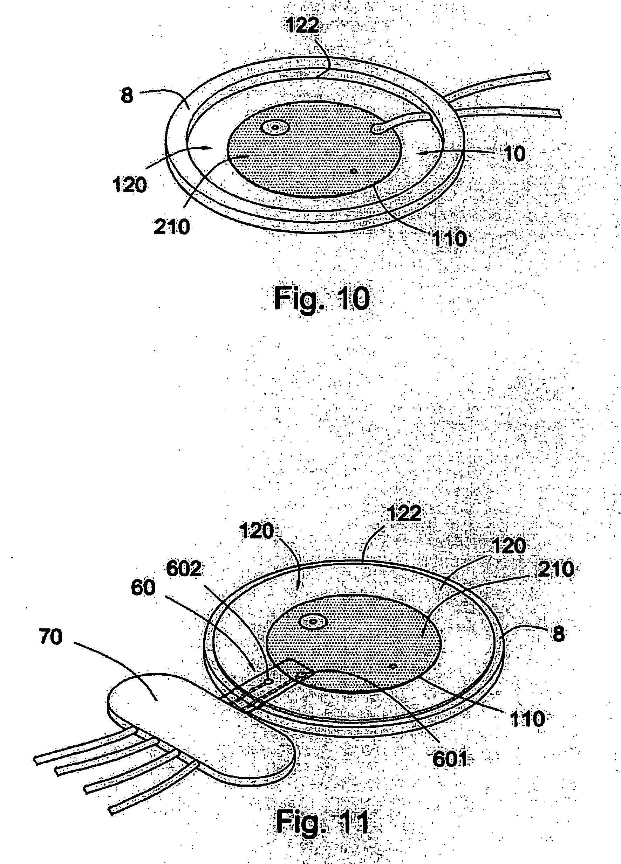

Referring to Figure 10, at least one circular piezoelectric element 10 is used to make a piezoelectric loudspeaker. The piezoelectric element 10 has the same structure of a piezoelectric ceramic unit 110 and a metal plate 120 as above-mentioned piezoelectric element 1. The metal plate 120 has an exposed boundary portion 122 with a damping pad 8 made of high resistant adhesive attached thereon to improve low-frequency sound quality.

Referring to Figure 11, in which the piezoelectric element 10 is flipped over, the piezoelectric loudspeaker can also be integrated with a driving circuit die 70 including a sound positive electrode, a sound negative electrode, a signal input and a standby mode as mentioned above. An output port of the die 70 includes a flexible printed circuit (FPC) 60 with a positive and a negative electrode output 601 and 602. The positive electrode output 601 is connected to each top silver layer 210 of the piezoelectric element 110 and the negative electrode output 602 is connected to the meal plate 120. So that the driving circuit die 70 can be integratedly formed with the piezoelectric loudspeaker.

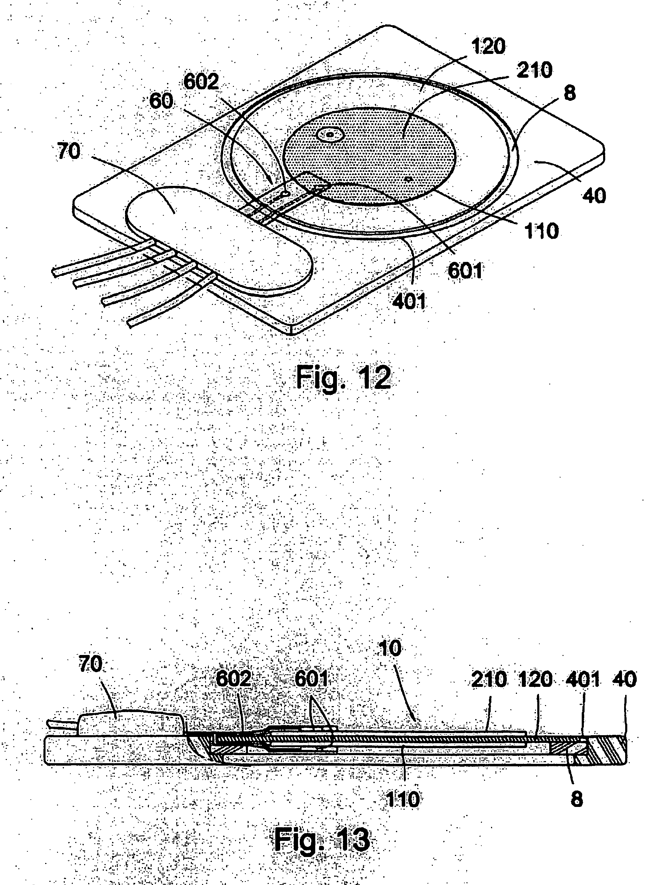

Alternatively, referring to Figures 12 and 13, an insulating base 40 including the driving circuit die 70 and a recess 401 is provided. The piezoelectric loudspeaker can utilize adhesion of the damping pad 8 to securely dispose in the recess 401.

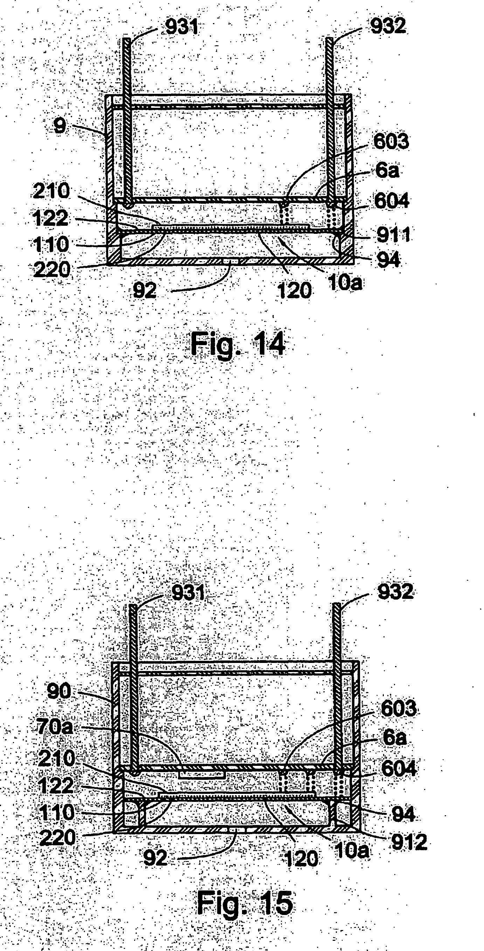

Furthermore, as shown in Figure 14, piezoelectric buzzer includes a circular piezoelectric element 10a and a housing 9. The circular piezoelectric element 10a is formed with a bottom silver layer 220 of a circular piezoelectric ceramic unit 110 attached on a circular metal plate 120. The boundary portion 122 of the metal plate 120 is used to securely fix on a clamping slot 911 of a housing 9 by silicon glue 94. An orifice 92 is formed on the bottom of the housing 9 to have the sound produced by the piezoelectric element 10a spoken out there through. A substrate board 6a is located inside the housing 9 above the piezoelectric element 10a. The substrate board 6a includes a positive electrode output 603 connected to a top silver layer 210 of the piezoelectric ceramic unit 110, and a negative electrode output 604 connected to the boundary portion 122 of the metal plate 120. Moreover, the substrate board 6a includes a positive electrode input 931 and a negative electrode input 932 for receiving source signals to drive the piezoelectric buzzer.

Referring to Figure 15, a driving circuit die 70a with a sound source positive electrode and a sound source negative electrode is disposed on the substrate board 6a and between the positive and the negative electrode outputs 603 and 604 and the positive and negative electrode inputs 931 and 932. The sound source positive electrode of the driving circuit die 70a is connected with the positive electrode input 931, and the sound source negative electrode of the driving circuit die 70a are connected with the negative electrode input 932. Moreover, the boundary portion 122 is securely fixed to an annular support 912 by the silicon glue 94 to install the piezoelectric element 10a in the housing 9.

Accordingly, the piezoelectric actuator, loudspeaker and buzzer of the present invention have compact electrode connection without messy extending conductive lines. Also, by using the piezoelectric element made of the piezoelectric ceramic unit with lower driving voltage, the applications of piezoelectric actuator, loudspeaker and buzzer can produce sound under lower driving voltage to stimulate resonance.

## Claims

1. A piezoelectric actuator comprising at least one piezoelectric element (1) mounted to an insulating bracket (4), the piezoelectric element (1; 10; 10a) comprising at least one piezoelectric ceramic unit (11; 110) attached to a metal plate (12; 120),
the piezoelectric ceramic unit comprising:
a top-layer (111), a bottom-layer (113) and an intermediate-layer ceramic sheet (112) stacked to each other;
a first alloy layer (31) of silver and palladium interposed between the top-layer and the intermediate-layer ceramic sheets (111, 112);
a second alloy layer (32) of silver and palladium interposed between the intermediate-layer and the bottom-layer and ceramic sheets (112, 113);
wherein a first insulating aperture (311) is formed on the first alloy layer (31), and a second insulating aperture (321) is formed on the second alloy layer (32),
wherein a positive electrode via hole (13) is formed to pass through all ceramic sheets (111, 112, 113) and the second alloy layer (32) but pass within the first insulating aperture (311), and a negative electrode via hole (14) is formed to pass through all ceramic sheets (111, 112, 113) and the first alloy layer (31) but pass within the second insulating aperture (321),
a top silver layer (21; 210) coated on an exposed surface of the top-layer ceramic sheet (111) and filled in the positive electrode via hole (13);
a bottom silver layer (22; 220) coated on an exposed surface of the bottom-layer ceramic sheet (112) and filled in the negative electrode via hole (14),
wherein a top insulating aperture (211) is formed on the top silver layer (21; 210) to insulate the top silver layer (21; 210) from the silver filled in the negative electrode via hole (14),
wherein a bottom insulating aperture (221) is formed on the bottom silver layer (112) to insulate the bottom silver layer (22, 220) from the silver filled in the positive electrode via hole (13),
thereby, the top silver layer (21; 210) and the second alloy layer (32) are connected by the silver filled in the positive electrode via hole (13) to form a
positive electrode circuit (130), and the bottom silver layer (22, 220) and the first alloy layer (31) are connected by the silver filled in the negative electrode via hole (14) to form a negative electrode circuit (140),
the metal plate (12; 120) with the bottom-layer ceramic sheet (113) is attached on one surface to connect the negative electrode circuit (140) so that an exposed end (121) can be used as a negative electrode terminal, and the top silver layer (21; 210) can be used as a positive electrode terminal;
the insulating bracket (4) comprising a positive electrode conductive part (41) contacted with the metal plate (12; 120), a negative electrode conductive part (42) contacted with the top silver layer (21) and at least one connecting pin (412, 413, 414, 422, 423, 424) extending from each of the positive and the negative electrode conductive part (41, 42) to receive voltage signals; and
a driving circuit die (7; 70; 70a) having an output port (75) connected to the connecting pins (412, 413, 414, 422, 423, 424) to be integratedly formed with the insulating bracket (4), and an input port with a sound positive electrode (71), a sound negative electrode (72), a signal input and a standby mode so that voltage signals can be transmitted to the piezoelectric element (1, 10, 10a).

2. The piezoelectric actuator of claim 1, further comprising a damping pad (8), wherein the negative electrode terminal is formed as an exposed boundary portion (122) and the damping pad (8) is adhered on the exposed boundary portion (122).

3. The piezoelectric actuator of claim 2, furthering comprising an insulating base (40) with a recess (401) for receiving the piezoelectric element adhered therein by the damping pad (8).

4. The piezoelectric actuator of claim 2 or 3, wherein the at least one piezoelectric element (10a) is mounted in a housing (9), wherein the housing (9) is including a substrate board (6a) with a positive electrode output (603) connected to the top silver layer (210), a negative electrode output (604) connected to the boundary portion (122) and a positive and a negative electrode input (931, 932) for receiving source signals.

5. The piezoelectric actuator of claim 4, wherein the boundary portion (122) is securely fixed on a clamping slot (911) of the housing (9).

6. The piezoelectric actuator of claim 4 or 5, wherein the boundary portion is securely fixed to an annular support (912) to install the piezoelectric element (10a) in the housing (9).

## Patentansprüche

1. Piezoelektrischer Antrieb mit wenigstens einem piezoelektrischen Element (1), das auf einer isolierenden Konsole (4) sitzt, wobei das piezoelektrische Element (1; 10; 10a) wenigstens eine piezoelektrische keramische Einheit (11; 110) umfaßt, die an einer Metallplatte (12; 120) befestigt ist, **dadurch gekennzeichnet, daß** die piezoelektrische keramische Einheit eine keramische Oberschichtplatte (111), Bodenschichtplatte (113) und Zwischenschichtplatte (112) aufweist, die übereinander liegen; daß eine erste Legierungsschicht (31) aus Silber und Palladium zwischen der Oberschicht und der keramischen Zwischenschicht (111, 112) angeordnet ist; daß eine zweite Legierungsschicht (32) aus Silber und Palladium zwischen der keramischen Zwischenschicht und der Bodenschicht (112, 113) angeordnet ist; wobei eine erste Isolierungsöffnung (311) auf der ersten Legierungsschicht (31) und eine zweite Isolierungsöffnung (321) auf der zweiten Legierungsschicht (32) ausgebildet sind, wobei ferner eine positive Elektrodenbohrung (13) so ausgebildet ist, daß sie sich durch alle Keramikplatten (111, 112, 113) und die zweite Legierungsschicht (32) erstreckt, jedoch in der ersten isolierenden Öffnung (311) verläuft, und daß eine negative Elektrodenbohrung (14) so ausgebildet ist, daß sie sich durch alle Keramikplatten (111, 112, 113) und die erste Legierungsschicht (31) erstreckt, jedoch innerhalb der zweiten isolierenden Öffnung (321) verläuft, daß eine obere Silberschicht (21; 210) auf einer freiliegenden Oberfläche der Oberschichtkeramikplatte (111) aufgebracht ist und in die positive Elektrodendurchgangsbohrung (13) eingebracht ist; daß eine untere Silberschicht (22; 220) auf einer freiliegenden Oberfläche der Unterschichtkeramikplatte (112) aufgebracht ist und in die negative Elektrodendurchgangsbohrung (14) gefüllt ist, daß ferner eine obere isolierende Öffnung (211) auf der oberen Silberschicht (21; 210) ausgebildet ist, um die obere Silberschicht (21; 210) von dem Silber zu isolieren, das in die negative Elektrodendurchgangsbohrung (14) eingefüllt ist, daß darüber hinaus eine untere isolierende Öffnung (221) auf der unteren Silberschicht (112) ausgebildet ist, um die untere Silberschicht (22, 220) von dem Silber zu isolieren, das in die positive Elektrodendurchgangsbohrung (13) eingefüllt ist, um dadurch die obere Silberschicht (21; 210) und die zweite Legierungsschicht (32) durch das Silber zu verbinden, das in die positive Elektrodendurchgangsbohrung (13) eingefüllt ist, so daß ein positiver Elektrodenschaltkreis (130) entsteht, und die untere Silberschicht (22, 220) sowie die erste Legierungsschicht (31) durch das Silber verbunden sind, das in die negative Elektrodendurchgangsbohrung (14) eingefüllt ist, um einen negativen Elektrodenschaltkreis (140) zu bilden, daß die Metallplatte (12; 120) mit der Bodenschichtkeramikplatte (113) auf der einen Oberfläche befestigt ist, um den negativen Elektrodenschaltkreis (140) so anzuschließen, daß ein freiliegendes Ende (121) als negativer Elektrodenanschluß benutzt werden kann und die obere Silberschicht (21; 210) als positiver Elektrodenanschluß benutzbar ist; daß des weiteren die isolierende Konsole (4) einen positiven Elektrodenleiterteil (41) aufweist, der mit der metallenen Platte (12; 120) in Berührung steht, ein negativer Elektrodenleiterteil (42) mit der oberen Silberschicht (21) in Berührung steht und wenigstens ein Verbindungszapfen (412, 413, 414, 422, 423, 424) von jedem positiven und jedem negativen Elektrodenleiterteil (41, 42) ausgeht, um Spannungssignale zu empfangen; und daß schließlich eine Antriebsschaltkreismatrize (7; 70; 70a), die eine Ausgangsöffnung (75) aufweist, mit den Anschlußzapfen (412, 413, 414, 422, 423, 424) in Verbindung steht, um mit dem isolierenden Arm (4) ein einheitliches Ganzes zu bilden, und eine Eingangsöffnung mit einer positiven Schallelektrode (71), einer negativen Schallelektrode (72), einem Signaleingang und einer Standby-Vorrichtung versehen ist, so daß Spannungssignale auf das piezoelektrische Element (1, 10, 10a) übertragen werden können.

2. Piezoelektrischer Antrieb nach Anspruch 1, des weiteren **gekennzeichnet durch** einen Dämpfungspuffer (8), wobei die negative Elektrodenanschlußklemme als freiliegender Begrenzungsteil (122) ausgebildet ist und der Dämfpungspuffer (8) auf dem freiliegenden Begrenzungsteil (122) haftet.

3. Piezoelektrischer Antrieb nach Anspruch 2, des weiteren **gekennzeichnet durch** eine isolierende Basis (40) mit einer Aussparung (401) zur Aufnahme des in ihm mit Hilfe des Dämpfungspuffers (8) haftenden piezoelektrischen Elements.

4. Piezoelektrischer Antrieb nach Anspruch 2 oder 3, **dadurch gekennzeichnet, daß** wenigstens das eine piezoelektrische Element (10a) in einem Gehäuse (9) gelagert ist, welches eine Substratplatte (6a) aufweist, versehen mit einem positiven Elektrodenausgang (603), welcher mit der oberen Silberschicht (210) verbunden ist, sowie einem negativen Elektrodenausgang (604), der mit dem Begrenzungsteil (122) in Verbindung steht, und mit einem positiven sowie einem negativen Elektrodeneingang (931, 932) zum Empfang von Quellensignalen.

5. Piezoelektrischer Antrieb nach Anspruch 4, **dadurch gekennzeichnet, daß** der Begrenzungsteil (122) auf einem Klemmschlitz (911) des Gehäuses (9) befestigt ist.

6. Piezoelektrischer Antrieb nach Anspruch 4 oder 5, **dadurch gekennzeichnet, daß** der Begrenzungsteil an einem ringförmigen Träger (912) befestigt ist, um das piezoelektrische Element (10a) in dem Gehäuse (9) zu installieren.

## Revendications

1. Actionneur piézo-électrique comprenant au moins un élément piézo-électrique (1) monté sur une platine isolante (4), l'élément piézo-électrique (1 ; 10 ; 10a) comprenant au moins une unité céramique piézo-électrique (11 ; 110) attachée sur une plaque métallique (12 ; 120),
l'unité céramique piézo-électrique comprenant :
une couche de sommet (111), une couche de fond (113) et une feuille céramique en couche intermédiaire (112) empilées les unes sur les autres ;
une première couche d'alliage (31) d'argent et de palladium interposée entre la couche de sommet et la feuille céramique de couche intermédiaire (111, 112) ;
une seconde couche d'alliage (32) d'argent et de palladium interposée entre la feuille céramique de couche intermédiaire et la feuille céramique de fond (112, 113) ;
dans lequel une première ouverture isolante (311) est formée sur la première couche d'alliage (31) et une seconde ouverture isolante (321) est formée sur la seconde couche d'alliage (32),
dans lequel un trou conducteur pour électrode positive (13) est formé de manière à traverser toutes les couches céramiques (111, 112, 113) et la seconde couche d'alliage (32) mais en passant dans la première ouverture isolante (311), et un trou conducteur pour électrode négative (14) est formé pour traverser toutes les couches céramiques (111, 112, 113) et la première couche d'alliage (31) mais en passant dans la seconde ouverture isolante (321),
une couche de sommet en argent (21 ; 210) revêtue sur une surface exposée de la feuille céramique de couche de sommet (111) est remplie dans le trou conducteur d'électrode positive (13) ;
une couche de fond en argent (22 ; 220) revêtue sur une surface exposée de la feuille céramique de couche de fond (112) est remplie dans le trou conducteur d'électrode négative (14), dans lequel une ouverture isolante supérieure (211) est formée sur la couche de sommet en argent (21 ; 210) pour isoler la couche de sommet en argent (21 ; 210) vis-à-vis de l'argent rempli dans le trou conducteur d'électrode négative (14),
dans lequel une ouverture isolante inférieure (221) est formée sur la couche de fond en argent (112) pour isoler la couche de fond en argent (22, 220) vis-à-vis de l'argent rempli dans le trou conducteur d'électrode positive (13),
grâce à quoi la couche de sommet en argent (21 ; 210) et la seconde couche d'alliage (32) sont connectées par l'argent rempli dans le trou conducteur d'électrode positive (13) pour former un circuit d'électrode positive (130), et la couche de fond en argent (22, 220) et la première couche d'alliage (31) sont connectées par l'argent rempli dans le trou conducteur d'électrode négative (14) pour former un circuit d'électrode négative (140),
la plaque métallique (12 ; 120) avec la feuille céramique de couche de fond (113) est attachée sur une surface pour connecter le circuit d'électrode négative (140) de telle façon qu'un terminal exposé (121) peut être utilisé à titre de borne d'électrode négative, et la couche de sommet en argent (21 ; 210) peut être utilisée à titre de borne d'électrode positive ;
la platine isolante (4) comprenant une partie conductrice formant électrode positive (41) en contact avec la plaque métallique (12 ; 120), une partie conductrice formant électrode négative (42) en contact avec la couche de sommet en argent (21), et au moins une broche de connexion (412, 413, 414, 422, 423, 424) s'étendant depuis chacune de la partie conductrice formant électrode positive et de la partie conductrice formant électrode négative (41, 42) pour recevoir des signaux de tension ; et
une puce de circuit pilote (7 ; 70 ; 70a) ayant un port de sortie (75) connecté aux broches de connexion (412, 413, 414, 422, 423, 424) pour être intégralement formé avec la platine isolante (4) et un port d'entrée avec une électrode positive de son (71), une électrode négative de son (72), une entrée à signaux et un mode d'attente tel que des signaux de voltage peuvent être transmis à l'élément piézo-électrique (1,10,10a).

2. Actionneur piézo-électrique selon la revendication 1, comprenant en outre un coussinet d'amortissement (8), dans lequel la borne d'électrode négative est formée comme une portion frontière exposée (122) et le coussinet d'amortissement (8) est adhéré sur la portion frontière exposée (122).

3. Actionneur piézo-électrique selon la revendication 2, comprenant en outre une base isolante (40) avec un évidement (401) pour recevoir l'élément piézo-électrique adhéré dans celui-ci par le coussinet d'amortissement (8).

4. Actionneur piézo-électrique selon la revendication 2 ou 3, dans lequel ledit au moins un élément piézo-électrique (10a) est monté dans un boîtier (9), ledit boîtier (9) incluant une carte de substrat (6a) avec une sortie d'électrode positive (603) connectée à la couche de sommet en argent (210), une sortie d'électrode négative (604) connectée à la portion frontière (122), ainsi qu'une entrée d'électrode positive et une entrée d'électrode négative (931, 932) pour recevoir des signaux source.

5. Actionneur piézo-électrique selon la revendication 4, dans lequel la portion frontière (122) est assurément fixée sur une fente de serrage (911) du boîtier (9).

6. Actionneur piézo-électrique selon la revendication 4 ou 5, dans lequel la portion frontière est assurément fixée sur un support annulaire (912) pour installer l'élément piézo-électrique (10a) dans le boîtier (9).
